# EUROPÄISCHE PATENTSCHRIFT

(11) **EP 3 030 864 B1**
(45) Veröffentlichungstag und Bekanntmachung des Hinweises auf die Patenterteilung: **03.01.2018**
(21) Anmeldenummer: 14741832.1
(22) Anmeldetag: 11.07.2014
(51) Int. Cl.: G01D 21/00, H01R 13/66, H03K 19/21

(54) **STECKVERBINDER**
PLUG TYPE CONNECTOR
CONNECTEUR ENFICHABLE

(30) Priorität: 07.08.2013 DE 102013108532
(43) Veröffentlichungstag der Anmeldung: 15.06.2016
(73) Patentinhaber: Endress+Hauser GmbH+Co. KG, 79689 Maulburg (DE)
(72) Erfinder: WERNET, Armin, 79618 Rheinfelden (DE); BECHTEL, Gerd, 79585 Steinen (DE); SCHRANK, Dirk, 79650 Schopfheim (DE)
(74) Vertreter: Andres, Angelika Maria
(86) Internationale Anmeldenummer: PCT/EP2014/064948
(87) Internationale Veröffentlichungsnummer: WO 2015/018597

(56) Entgegenhaltungen:
- EP-A1- 1 251 596
- DE-A1-102006 005 632
- DE-A1-102006 006 726
- DE-A1-102009 029 042
- US-A1- 2006 061 365

## Beschreibung

Die Erfindung betrifft einen Steckverbinder zum Verbinden eines Feldgeräts der Automatisierungstechnik, insbesondere eines Grenzstandschalters, mit einer Energieversorgung und/oder einer Auswerteeinheit.

In der Automatisierungstechnik, insbesondere in der Prozessautomatisierungstechnik, werden Feldgeräte eingesetzt, die zur Bestimmung und Überwachung von Prozessvariablen dienen. Beispiele für derartige Feldgeräte sind Füllstandsmessgeräte, Durchflussmessgeräte, Analysemessgeräte, Druck- und Temperaturmessgeräte, Feuchte- und Leitfähigkeitsmessgeräte, Dichte und Viskositätsmessgeräte. Die Sensoren dieser Feldgeräte erfassen die entsprechenden Prozessvariablen, z.B. den Füllstand, den Durchfluss, den pH-Wert, die Stoffkonzentration, den Druck, die Temperatur, die Feuchte, die Leitfähigkeit, die Dichte oder die Viskosität. Eine Vielzahl solcher Feldgeräte wird von der Firmengruppe Endress + Hauser angeboten und vertrieben.

Unter der Bezeichnung LIQUIPHANT, LIQUIPOINT und SOLIPHANT werden von der Anmelderin Sensoren zur Detektion eines vorgegebenen Füllstands angeboten und vertrieben. Sie werden bevorzugt als Trockenlaufschutz für Pumpen oder als Überfüllsicherung eingesetzt und haben üblicherweise zwei antivalente Schaltausgänge, über die der jeweilige Schaltzustand des Feldgeräts ausgegeben wird. Diese auch als Grenzstandschalter bezeichneten Sensoren weisen aus Dichtigkeits- und/oder Platzgründen oftmals keine integrierten optischen Anzeigen (LED) für die beiden antivalenten Schaltausgänge auf. Insbesondere ist dies bei gekapselten Feldgeräten der Fall, die dem IP69K Standard genügen. Da die Vor-Ort-Information über den jeweiligen Schaltausgang bzw. Schaltzustand des Grenzstandschalters für einen Kunden üblicherweise jedoch sehr wichtig ist, werden LEDs, die die Schaltausgänge visualisieren, in den mit dem Sensor verbundenen Anschlussstecker des Steckverbinders integriert. Als Anschlussstecker werden in der Automatisierungstechnik oftmals M12 Stecker verwendet. Die auf dem Markt angebotenen Anschlussstecker für Feldgeräte sind zwar in der Lage, über LEDs die beiden antivalenten Schaltausgänge und die Betriebsspannung zu visualisieren; jedoch sind sie nicht in der Lage, zusätzlich Stör- oder Fehlfunktionen des Feldgeräts vor Ort (also am Ort der Montage im Prozess) zur Anzeige zu bringen. Somit fehlt dem Kunden eine für den Betrieb der Anlage, in der das Feldgerät installiert ist, äußerst wichtige Vor-Ort-Information. Der Nachteil bei der bekannten Ausgestaltung des Anschlusssteckers ist insbesondere darin zu sehen, dass ein defektes oder fehlerhaft arbeitendes Feldgerät erst mit einer mehr oder weniger großen Zeitverzögerung ausgetauscht werden kann, da eine Servicekraft vor Ort die Stör- oder Fehlfunktion nicht unmittelbar erkennt. Die Funktionstüchtigkeit der Anlage kann daher aufgrund einer Fehlfunktion des Feldgeräts u.U. erheblich beeinträchtigt sein.

Aus der DE102006005632A1 ist ein Verbindungssystem mit einer Eingabeeinheit und einem Verbindungselement zur Eingabe von sensorrelevanten Befehlen bekannt geworden. Das System kann ferner einer optische Diagnose-Anzeigeeinheit aufweisen, mittels derer befehlsrelevante Meldungen, beispielsweise der ordnungsgemäße Zustand der Energieversorgung, eine fehlerhafte, oder gestörte Datenüberragung oder auch der Sensorstatus angezeigt werden können.

Die DE102009029042A1 beschreibt ein Messgerät mit einer Elektronikeinheit und einer als Teil einer Steckverbindung ausgestalteten Schnittstelle. Für einen Grenzstandschalter stehen beispielsweise zwei verschieden ausgeführte Steckerelemente für die Inbetriebnahme des Messgeräts zur Verfügung.

Der Erfindung liegt die Aufgabe zugrunde, ein Feldgerät vorzuschlagen, das eine Stör- oder Fehlfunktion vor Ort zur Anzeige bringt.

Die Aufgabe wird gelöst durch einen Steckverbinder zum Verbinden eines Feldgeräts der Automatisierungstechnik mit einer Energieversorgung und/oder einer Auswerteeinheit, wobei der Steckverbinder einen Anschlussstecker für das Feldgerät aufweist, der zumindest teilweise aus einem transparenten Material besteht, wobei in dem Anschlussstecker mindestens vier Anzeigeelemente angeordnet sind, wobei ein erstes Anzeigeelement die Betriebsbereitschaft des Feldgeräts signalisiert, wobei ein zweites und ein drittes Anzeigeelemente zwei antivalente Schaltausgänge (im Falle eines Grenzstandschalters spricht man von MAX- und MIN Sicherheit) des Feldgeräts signalisieren, wobei ein viertes Anzeigeelement eine Stör- oder Fehlfunktion des Feldgeräts signalisiert, wobei eine Schaltung vorgesehen ist, die so ausgestaltet ist, dass anhand der antivalenten Schaltausgänge des Feldgeräts eine Stör- oder Fehlfunktion des Feldgeräts erkannt und bei Erkennen einer Stör- oder Fehlfunktion das vierte Anzeigeelement aktiviert wird. Bei den Anzeigeelementen handelt es sich bevorzugt um LEDs.

Um neben der Anzeige der Betriebsspannung und der antivalenten Schaltaus-gänge auch eine Stör-oder Fehlersignalisierung im Anschlussstecker des Feldgeräts zu integrieren, erfolgt erfindungsgemäß eine logische Verschaltung der beiden Schaftausgänge. Da die Abmessungen des Anschlusssteckers relativ begrenzt sind, kann im Falle eines z.B. LIQUIPHANT nur eine Schaltung mit möglichst wenigen Bauteilen eingesetzt werden.

Erfindungsgemäß werden die antivalenten Schaltausgänge betrachtet, um eine Stör-oder Fehlfunktion vor Ort darzustellen. Je nach Schaltausgang - MIN oder MAX-Sicherheit - ist ein Schaltausgang bei bedecktem Grenzstandschalter geschaltet oder nicht. In den herkömmlichen Anschlusssteckern sind bei Auftreten einer Stör-oder Fehlfunktion beide entsprechenden LEDs, die in gelber Farbe leuchten, ausgeschaltet, und nur die grüne LED, die das Anliegen der Betriebsspannung anzeigt, leuchtet. Es ist fraglich, ob das Bedienpersonal diese LED Beschaltung als Stör- oder Fehlfunktion deutet. Erfindungsgemäß wird die Stör- oder Fehlfunktion unmissverständlich und eindeutig signalisiert: Tritt eine Stör- oder Fehlfunktion auf, so wird diese durch Aufleuchten einer zusätzlichen roten LED am Einbauort des Feldgeräts angezeigt.

Der Betrieb des Feldgeräts wird durch kontinuierliches Aufleuchten einer ersten LED, üblicherweise eine grüne LED, angezeigt. Bei korrektem Betrieb des Feldgeräts bringen die beiden antivalenten Schaltausgänge die zweite oder die dritte LED (üblicherweise handelt es sich hierbei um gelbe LEDs) zum Leuchten. Sind beide gelben LEDs ausgeschaltet, was erfindungsgemäß als Stör- oder Fehlfunktion identifiziert wird, leuchtet eine zusätzliche LED auf. Üblicherweise handelt es sich hierbei um eine rote LED.

Erfindungsgemäß wird die Identifizierung einer Stör- oder Fehlfunktion am Feldgerät über eine in den Stecker integrierte NOR oder XNOR Schaltung realisiert. Hierbei ist die XNOR Schaltung die sichere Variante, weil auch der Zustand, dass beide antivalenten Schaltausgänge MIN und MAX gleichzeitig geschaltet sind, keinen normalen Betriebszustand, sondern eine Stör- oder Fehlfunktion darstellt. Allerdings sind herkömmliche Umsetzungen dieser Schaltungen bei Anschlusssteckern für Feldgeräte mit kleinen Abmessungen nicht praktikabel. Beispielsweise würde ein Aufbau in CMOS-Technik den Platzbedarf bei üblichen Grenzstandschaltern übersteigen.

Dennoch sieht, je nach verwendetem Anschlussstecker, eine erste Ausgestaltung vor, dass die logische Schaltung in CMOS Technik realisiert ist. Darüber hinaus ist vorgesehen, dass die logische Schaltung mit einem integrierten Gatter realisiert ist. Bevorzugt ist die logische Schaltung auf einem integrierten Chip realisiert.

Eine vorteilhafte Weiterbildung des erfindungsgemäßen Steckverbinders schlägt eine logische Schaltung mit einem Schaltelement vor, wobei das Schaltelement so ausgestaltet ist, dass es bei Auftreten einer Stör- oder Fehlfunktion, die anhand der angeschlossenen antivalenten Schaltausgänge erkannt wird, das nachgeschaltete vierte Anzeigeelement aktiviert.

Als besonders günstig wird es in Verbindung mit der Erfindung angesehen, wenn es sich bei dem Schaltelement um einen bipolaren Transistor, insbesondere um einen pnp Transistor, handelt, in dessen Basiszweig das zweite Anzeigeelement und das dritte Anzeigeelement parallel geschaltet sind und in dessen Kollektorzweig das vierte Anzeigeelement angeordnet ist, wobei der Transistor so beschaltet ist, dass er im Normalbetrieb sperrt und bei Auftreten einer Stör- oder Fehlfunktion leitend wird.

Darüber hinaus wird vorgeschlagen, dass die logische Schaltung so ausgestaltet ist, dass das zweite Anzeigeelement und das dritte Anzeigeelement parallel geschaltet sind und das vierte Anzeigeelement in Reihe mit dem zweiten und dem dritten Anzeigeelement geschaltet ist, dass im Normalbetrieb die Spannung an einem zwischen den beiden parallelgeschalteten Anzeigeelementen und dem vierten Anzeigeelement liegenden Knoten das Potential so niedrig ist, dass das vierte Anzeigeelement deaktiviert ist, und dass bei Auftreten einer Stör- oder Fehlfunktion das Potential an dem Knoten so hoch ist, dass das vierte Anzeigeelement aktiviert wird.

Eine vorteilhafte Ausgestaltung der erfindungsgemäßen Lösung sieht vor, dass zumindest im Anodenzweig der vierten Leuchtdiode eine Schutzdiode, insbesondere eine Zenerdiode vorgesehen ist.

Die Erfindung wird anhand der nachfolgenden Figuren näher erläutert. Es zeigt:
Fig. 1a: eine Seitenansicht eines bekannten Anschlusssteckers M12 für ein Feldgerät,
Fig. 1b: die Kontaktbelegung eines bekannten Anschlusssteckers M12 mit drei integrierten LEDs,
Fig. 2: die Kontaktierung eines bekannten Anschlusssteckers M12, wenn zwei Schaltausgänge vorhanden sind,
Fig. 3: eine schematische Darstellung von unterschiedlichen Sicherheitsfunktionen eines bekannten Grenzschalters,
Fig. 4: die Pegelverläufe an den Schaltausgängen eines Grenzstandschalters,
Fig. 5: eine Draufsicht auf eine Ausgestaltung des erfindungsgemäßen Steckverbinders in schematischer Darstellung,
Fig. 6a: eine Darstellung einer Schalttabelle für eine NOR Schaltung,
Fig. 6b: eine Darstellung einer Schalttabelle für einen XNOR Schaltung,
Fig. 7: eine Darstellung eines logischen CMOS basierten Gatters NOR,
Fig. 7b: eine Darstellung eines logischen CMOS basierten Gatters XNOR,
Fig. 8: eine vorteilhafte Ausgestaltung des erfindungsgemäßen Steckverbinders mit einem logischen Gatter,
Fig. 9: ein Schaltbild einer ersten bevorzugten elektrischen Schaltung zur Beschaltung der Anzeigeelemente des erfindungsgemäßen Steckverbinders und
Fig. 10: ein Schaltbild einer zweiten bevorzugten elektrischen Schaltung zur Beschaltung der Anzeigeelemente des erfindungsgemäßen Steckverbinders.

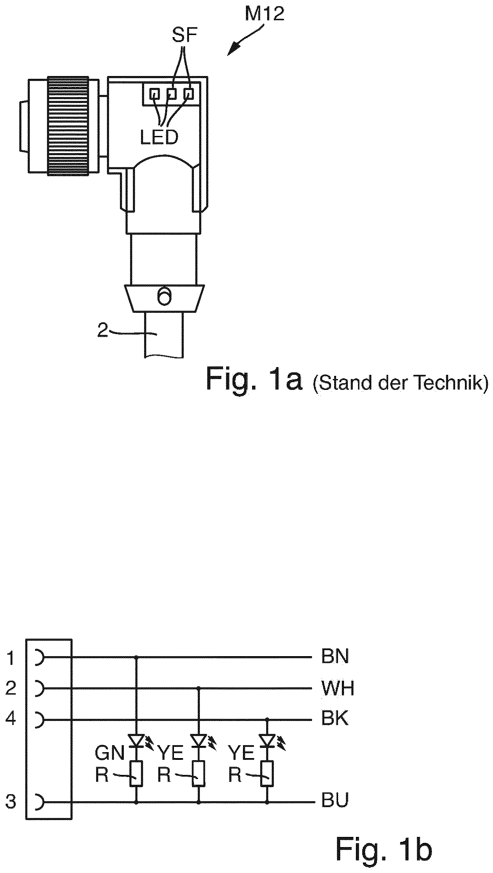

In Fig. 1a ist ein aus dem Stand der Technik bekannter Anschlussstecker M12 eines Steckverbinders für ein Feldgerät dargestellt. Der erfindungsgemäße Steckverbinder, bestehend aus Anschlussstecker M12 und Kabel 2, verbindet das nicht gesondert dargestellte Feldgerät mit einer nicht gesondert dargestellten Energieversorgung und/oder einer Auswerteeinheit.

Eine Schaltung zur Ansteuerung der drei in dem Anschlussstecker M12 angeordneten LEDs gn, ye, ye ist in Fig. 1b gezeigt: In jeder der drei Leitungen ist jeweils eine LED gn, ye, ye mit einem Vorwiderstand R zur Strombegrenzung angeordnet. Die LED gn, die die Betriebsbereitschaft des Feldgeräts anzeigt, leuchtet in grüner Farbe gn, während die beiden LEDs ye, ye, die die Schaltausgänge MIN, MAX anzeigen, in gelber Farbe leuchten.

Fig. 1b zeigt die Kontaktbelegung eines bekannten Anschlusssteckers M12 mit drei integrierten LEDs gn ye, ye.

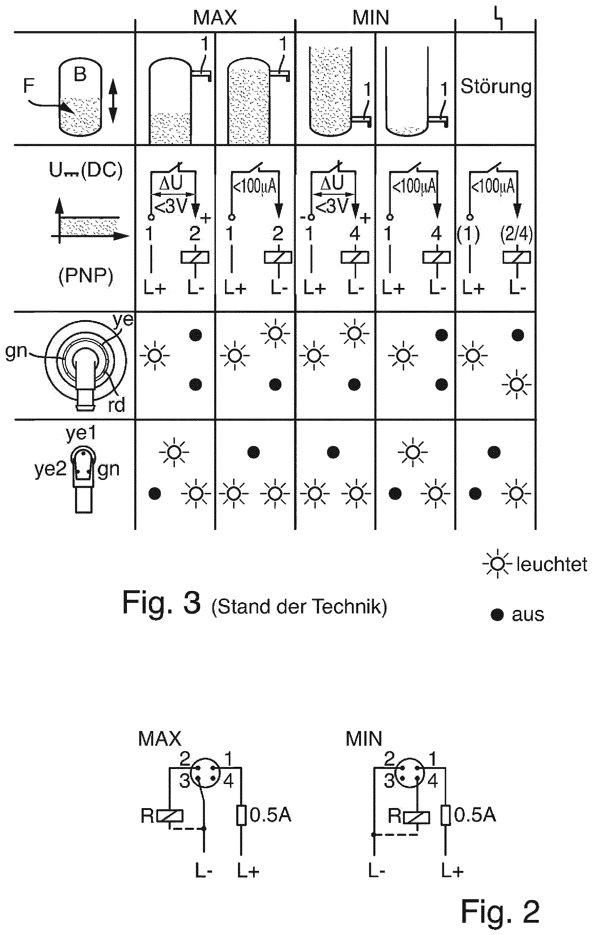

Fig. 2 zeigt die Kontaktierung eines bekannten M12 Steckers, wenn zwei Schaltausgänge MIN, MAX vorhanden sind. Insbesondere sind in Fig. 2 die unterschiedlichen Anschlussarten für die MIN- und MAX-SicherheitsSchaltausgänge MIN, MAX sowie die PIN- und Farbenzuordnung des Anschlusssteckers M12 und der Leitungen dargestellt.

Fig. 3 zeigt eine schematische Darstellung von unterschiedlichen Sicherheitsfunktionen eines Grenzschalters 1 sowie eine Darstellung des bekannten Anschlusssteckers M12 Steckers mit drei LEDs gn ye, ye. Der Anschlussstecker M12 beinhaltet vier Leitungen: eine Leitung für die Versorgungsspannung, eine Leitung für den Masseanschluss GND, einen MIN-Sicherheitsschaltausgang und einen MAX-Sicherheitsschaltausgang. Fig. 3 visualisiert die aus dem Stand der Technik bekannte Funktion der LEDs gn ye, ye bei den verschiedenen Sicherheitsfunktionen: maximaler Füllstand ist erreicht und minimaler Füllstand ist erreicht. In der obersten Zeile sind die möglichen Füllstände in einem Behälter B gezeigt. Der Füllstand F in dem Behälter B verändert sich. Bei Verwendung eines Grenzstandschalters 1 als Überfüllsicherung ist der Grenzstandschalter 1 auf der Höhe des maximal zulässigen Füllstands montiert. Bei Verwendung des Grenzstandschalters 1 als Trockenlaufschutz für Pumpen ist der Grenzstandschalter 1 auf der Höhe des minimal zulässigen Füllstands positioniert. In der zweiten Zeile von Fig. 3 sind die entsprechenden Beschaltungen des Grenzstanddetektors 1 gezeigt. In der dritten Zeile und der vierten Zeile von Fig. 3 sind die Anzeigeelemente LED gn ye, ye gezeigt, die je nach Schaltausgang MIN, MAX aufleuchten oder deaktiviert sind: In der dritten Zeile sind die LEDs gn ye, ye in dem Feldgerät integriert, während sie in der vierten Zeile in dem Anschlussstecker M12 für das Feldgerät integriert sind.

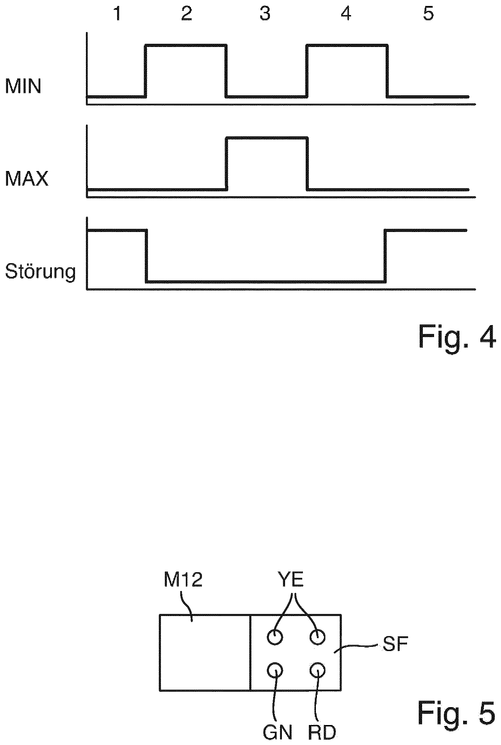

In Fig. 4 sind die Pegelverläufe bei einem Grenzstandschalter 1 mit zwei Sicherheitsschaltausgängen MIN, MAX gemäß der Erfindung gezeigt. Fig. 5 zeigt eine Draufsicht auf eine Ausgestaltung des Anschlusssteckers M12 des erfindungsgemäßen Steckverbinders mit dem transparenten Fenster SF und vier LEDs gn ye, ye, rd.

Wenn der Grenzstandschalter 1 korrekt funktioniert und den Pegel 1 ausgibt - dies ist in den mit 2, 3 und 4 in Fig. 4 gekennzeichneten Zeitbereichen der Fall -, so leuchtet eine der beiden gelben LEDs ye, ye auf. Ein Fehlerfall liegt vor, wenn beide Sicherheitsschaltausgänge MIN, MAX gleichzeitig auf Pegel 0 sind und folglich keine der beiden gelben LEDs aufleuchtet. In diesem Fall wird eine Störung durch Einschalten der roten LED rd signalisiert.

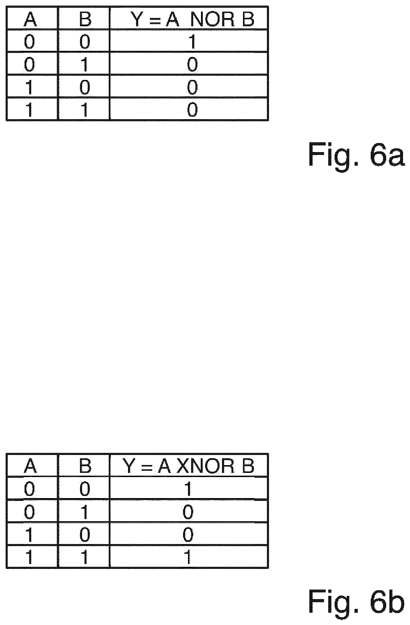

In den Fig. 6a ist eine Schalttabelle für eine NOR Schaltung und in Fig. 6b eine Schalttabelle für eine XNOR Schaltung dargestellt. Über entsprechende logische Schaltungen NOR, XNOR lassen sich die vier LEDs gn ye, ye, rd in der erfindungsgemäßen Art und Weise beschalten. A kennzeichnet beispielsweise den Schaltausgang MIN, dann kennzeichnet B den Schaltausgang MAX. Bei der NOR Schaltung wird ein Alarm gesetzt, bzw. die rote LED rd wird aktiviert, wenn beide Schaltausgänge MIN, MAX auf dem Pegel 0 sind. Bei der XNOR Schaltung wird die rote LED rd zusätzlich aktiviert, wenn die Schaltausgänge MIN, MAX gleichzeitig auf dem Pegel 1 sind. Wie bereits zuvor erwähnt, ist die XNOR Schaltung die sichere Variante, weil auch der Zustand, dass beide antivalenten Schaltausgänge MIN und MAX gleichzeitig auf dem Pegel 1 sind, keinen normalen Betriebszustand, sondern eine Stör- oder Fehlfunktion darstellt. Allerdings sind herkömmliche Umsetzungen dieser Schaltungen bei Anschlusssteckern M12 für Feldgeräte mit kleinen Abmessungen nicht praktikabel. Es genügt hier, den zuerst genannten Fehlerfall zu signalisieren.

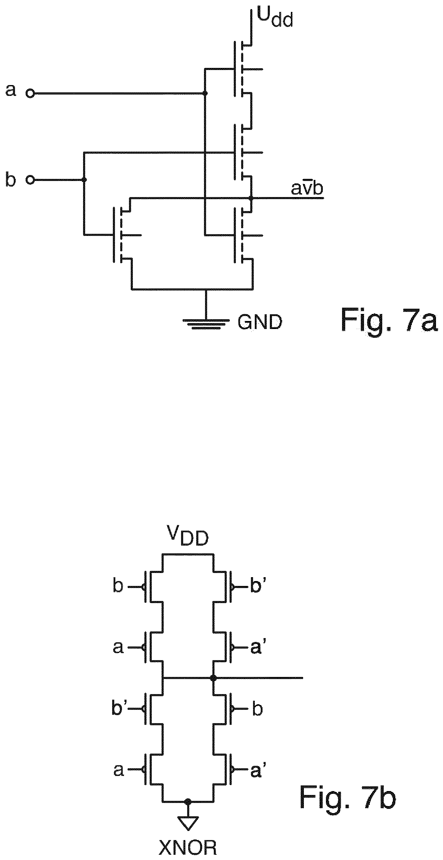

In Fig. 7a ist eine Darstellung eines logischen auf CMOS-Technik basierenden Gatters NOR zu sehen; in Fig. 7b ist ein logisches auf CMOS-Technik basierendes Gatter XNOR dargestellt. Mit diesen beiden logischen Gattern NOR, XNOR lässt sich der erfindungsgemäße Steckverbinder realisieren.

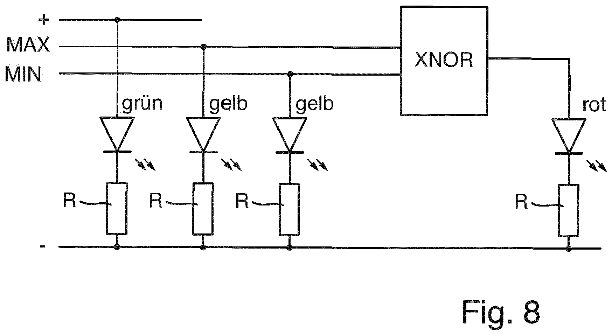

Fig. 8 zeigt eine vorteilhafte Ausgestaltung des erfindungsgemäßen Steckverbinders mit einem logischen Gatter XNOR zur Verschaltung der Schaltausgänge MIN, MAX eines Grenzstandschalters 1. Über das logische Gatter XNOR wird die rote LED rd aktiviert, sobald beide Schaltausgänge MIN, MAX des Grenzstandschalters auf dem gleichen Pegel 0 oder 1 sind. Die grüne LED gn leuchtet, wenn das Feldgerät mit Spannung versorgt wird. Jeder der LEDs gn ye, ye, rd ist ein Vorwiderstand R zur Strombegrenzung zugeordnet. Die gezeigte Schaltung ist bestens zur Umsetzung der erfindungsgemäßen Lösung geeignet. Allerdings sind aktuell keine Standard-Bauteile auf dem Markt erhältlich, welche für Eingangsspannungen bis 24V oder mehr geeignet sind. Dieser Spannungsbereich ist der Nennbereich für Applikationen in der Automatisierungstechnik und muss auf jeden Fall abgedeckt werden. Darüber hinaus ist es für Verwendung der erfindungsgemäßen Lösung bei einem Grenzstandschalter 1 unumgänglich, einen integrierten Chip mit kleiner Baugröße zu verwenden, da das Platzangebot in dem Anschlussstecker M12 eingeschränkt ist.

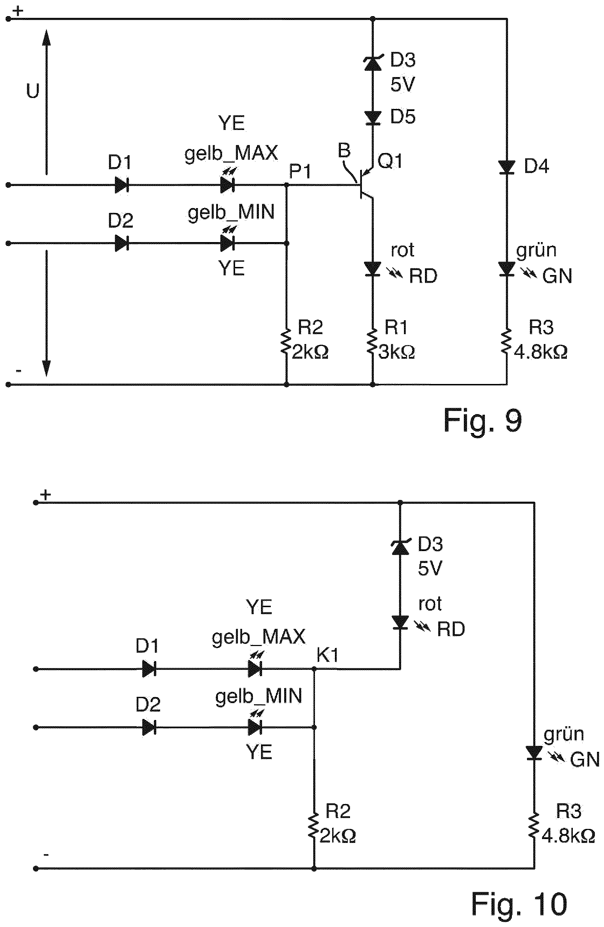

In Fig. 9 ist ein Schaltbild einer bevorzugten elektrischen Schaltung zur Beschaltung der LEDs gn ye, ye, rd des erfindungsgemäßen Steckverbinders zu sehen. Die gezeigte Schaltung benötigt wenige Schaltelemente und lässt sich auch bei geringem Platzbedarf realisieren, so dass sie auch in einem Anschlussstecker M12 untergebracht werden kann. Jeder LED gn ye, ye, rd ist eine Diode D1, D2, D4, D5 als Überspannungsschutz und Verpolschutz zugeordnet. Ggf. können die den LEDs gn ye, ye, rd zugeordneten Schutzdioden D1, D2, D4, D5 auch eingespart werden.

In der Schaltung ist ein Transistor Q1, hier ein PNP Transistor, verbaut, der leitend wird, sobald die Spannung an der Basis B einen vorgegebenen Spannungswert unterschreitet. Im normalen Betriebsfall, d.h. solange entweder der Schaltausgang MIN oder der Schaltausgang MAX auf Pegel 1 ist, befindet sich der Schaltungspunkt P1 auf einem hohen Potential und der der Transistor Q1 ist im Sperrbetrieb. Folglich bleibt die rote LED rd deaktiviert. Zu beachten ist, dass aufgrund der Endstufe des DC-PNP Schaltausgangs MIN, MAX und aufgrund der Schutzdioden D1, D2 sowie der LEDs ye, ye nicht die Versorgungsspannung U an dem Schaltungspunkt P1 anliegt, sondern eine um die jeweiligen Spannungsabfälle verringerte Spannung. Um sicherzustellen, dass der pnp Transistor Q1 sicher sperrt, wenn nur einer der beiden Schaltausgänge MIN, MAX geschaltet ist, wird eine Zener Diode D3 verwendet. Da der Transistor Q1 sperrt, wird die rote eine Stör- oder Fehlfunktion anzeigende LED rd nicht aktiviert.

Eine kosten- und platzoptimierte Umsetzung der Erfindung ist in Fig. 10 dargestellt. In dieser Umsetzung werden sowohl der pnp Transistor Q1 als auch drei weitere Bauteile eingespart. Die Schaltung hat ansonsten dieselbe Funktion wie die Schaltung aus Fig. 9. Ist einer der beiden Schaltausgänge MIN, MAX durchgeschaltet und somit auf Pegel 1, wird eine der beiden gelben LEDs ye, ye leuchten und das Potential am Knotenpunkt K1 anheben. Die rote eine Stör- oder Fehlfunktion anzeigende LED rd leuchtet nicht, da keine positive Spannung zwischen dem Knotenpunkt K1 und der Anode der roten LED rd anliegt. Dies wird ebenfalls durch eine Zener-Diode D3 sichergestellt.

Sind beide Schaltausgänge MIN, MAX gesperrt, liegt an dem Knotenpunkt K1 ein kleines Potential. Somit liegt an der roten LED rd eine Spannung an, und sie leuchtet auf, um die Stör- oder Fehlfunktion zu signalisieren. In einer vorteilhaften Ausgestaltung können der Platzbedarf und die Kosten noch dadurch reduziert werden, dass die Schutzdioden D1, D2, die den LEDs ye, ye vorgeschaltet sind, weggelassen werden.

## Patentansprüche

1. Steckverbinder zum Verbinden eines Feldgeräts der Automatisierungstechnik mit einer Energieversorgung und/oder einer Auswerteeinheit, wobei der Steckverbinder einen Anschlussstecker (M12) für das Feldgerät aufweist, der zumindest teilweise aus einem transparenten Material besteht, wobei in dem Anschlussstecker (M12) mindestens vier Anzeigeelemente (gn ye, ye, rd) angeordnet sind, wobei ein erstes Anzeigeelement (gn) die Betriebsbereitschaft des Feldgeräts signalisiert, wobei ein zweites und ein drittes Anzeigeelement (ye, ye) zwei antivalente Schaltausgänge (MIN, MAX) des Feldgeräts signalisieren, wobei ein viertes Anzeigeelement (rd) eine Stör- oder Fehlfunktion des Feldgeräts signalisiert, wobei eine Schaltung (NOR, XNOR) vorgesehen ist, die so ausgestaltet ist, dass anhand der antivalenten Schaltausgänge (MIN, MAX) des Feldgeräts eine Stör- oder Fehlfunktion des Feldgeräts erkannt und bei Erkennen einer Stör- oder Fehlfunktion das vierte Anzeigeelement (rd) aktiviert wird, und
wobei es sich bei der Schaltung um eine logische Schaltung (NOR, XNOR) handelt, die als NOR oder als XNOR Schaltung ausgelegt ist.

2. Steckverbinder nach Anspruch 1,
wobei die logische Schaltung (NOR, XNOR) in CMOS Technik realisiert ist.

3. Steckverbinder nach Anspruch 1
wobei die logische Schaltung (NOR, XNOR) mit einem integrierten Gatter realisiert ist.

4. Steckverbinder nach Anspruch 1-oder 3 ,
wobei die logische Schaltung (NOR, XNOR) auf einem integrierten Chip realisiert ist.

5. Steckverbinder nach Anspruch 1,
wobei die logische Schaltung (NOR, XNOR) ein Schaltelement (Q1) aufweist, das so ausgestaltet ist, dass es bei Auftreten einer Stör- oder Fehlfunktion, die anhand der angeschlossenen antivalenten Schaltausgänge (MIN, MAX) erkannt wird, das nachgeschaltete vierte Anzeigeelement (rd) aktiviert.

6. Steckverbinder nach Anspruch 5,
wobei es sich bei dem Schaltelement (Q1) um einen bipolaren Transistor, insbesondere um einen pnp Transistor, handelt, in dessen Basiszweig (B) das zweite Anzeigeelement (ye) und das dritte Anzeigeelement (ye) parallel geschaltet sind und in dessen Kollektorzweig (K) das vierte Anzeigeelement (rd) angeordnet ist, wobei der Transistor (Q1) so beschaltet ist, dass er im Normalbetrieb sperrt und bei Auftreten einer Stör- oder Fehlfunktion leitend wird.

7. Steckverbinder nach Anspruch 1,
wobei die logische Schaltung (NOR, XNOR) so ausgestaltet ist, dass das zweite Anzeigeelement (ye) und das dritte Anzeigeelement (ye) parallel geschaltet sind und das vierte Anzeigeelement (rd) in Reihe mit dem zweiten Anzeigeelement (ye) und dem dritten Anzeigeelement (ye) geschaltet ist, dass im Normalbetrieb die Spannung an einem zwischen den beiden parallelgeschalteten Anzeigeelementen (ye, ye) und dem vierten Anzeigeelement (rd) liegenden Knoten (P1, K1) das Potential so niedrig ist, dass das vierte Anzeigeelement (rd) deaktiviert ist, und dass bei Auftreten einer Stör- oder Fehlfunktion das Potential an dem Knoten (P1, K1) so hoch ist, dass das vierte Anzeigeelement (rd) aktiviert wird.

8. Steckverbinder nach einem oder mehreren der vorhergehenden Ansprüche,
wobei es sich bei den Anzeigeelementen (gn ye, ye, rd) um Leuchtdioden (LED) handelt, wobei die erste Leuchtdiode (gn) in einer ersten Farbe, bevorzugt in grüner Farbe leuchtet und den Betriebszustand des Feldgeräts charakterisiert, wobei die zweite und die dritte Leuchtdiode (ye, ye) in einer zweiten Farbe, bevorzugt in gelber Farbe leuchten und die beiden antivalenten Schaltausgänge (MIN, MAX) anzeigen, und wobei die vierte Leuchtdiode (rd) in einer dritten Farbe, bevorzugt in roter Farbe leuchtet und die Stör- und/oder Fehlfunktion signalisiert.

9. Steckverbinder nach Anspruch 8,
wobei zumindest im Anodenzweig der vierten Leuchtdiode (rd) eine Zenerdiode (D3) vorgesehen ist.

## Claims

1. Plug-in connector for connecting a field device used in automation engineering with a power supply system and/or a evaluation unit, wherein the plug-in connector has a plug (M12) for the field device, which consists of a transparent material at least in part, wherein at least four indicator elements (gn, ye, ye, rd) are arranged in the plug (M12), wherein a first indicator element (gn) signals the operational readiness of the field device, wherein a second and third indicator element (ye, ye) signal two antivalent switch outputs (MIN, MAX) of the field device, wherein a fourth indicator element (rd) signals a disturbance or malfunction of the field device, wherein a circuit (NOR, XNOR) is provided that is designed in such a way that a disturbance or malfunction of the field device is detected using the antivalent switch outputs (MIN, MAX) of the field device and that the fourth indicator element (rd) is activated if a disturbance or malfunction is detected, and
wherein the circuit is a logical circuit (NOR, XNOR), which is designed as a NOR or XNOR circuit.

2. Plug-in connector as claimed in Claim 1,
wherein the logical circuit (NOR, XNOR) is implemented with CMOS technology.

3. Plug-in connector as claimed in Claim 1,
wherein the logical circuit (NOR, XNOR) is implemented with an integrated gate.

4. Plug-in connector as claimed in Claim 1 or 3,
wherein the logical circuit (NOR, XNOR) is implemented on an integrated chip.

5. Plug-in connector as claimed in Claim 1,
wherein the logical circuit (NOR, XNOR) has a switching element (Q1) which is designed in such a way that the downstream fourth indicator element (rd) is activated if a disturbance or malfunction occurs which is detected by the connected antivalent switch outputs (MIN, MAX).

6. Plug-in connector as claimed in Claim 5,
wherein the switching element (Q1) is a bipolar transistor, particularly a pnp transistor, in the basic branch (B) of which the second indicator element (ye) and the third indicator element (ye) are switched in parallel and in the collector branch (K) of which the fourth indicator element (rd) is arranged, wherein the transistor (Q1) is wired in such a way that it is blocked during normal operation and is conductive when a disturbance or malfunction occurs.

7. Plug-in connector as claimed in Claim 1,
wherein the logical circuit (NOR, XNOR) is designed in such a way that the second indicator element (ye) and the third indicator element (ye) are switched in parallel and in that the fourth indicator element (rd) is switched in series with the second indicator element (ye) and the third indicator element (ye), in that, during normal operation, the voltage at a node (P1, K1) situated between the two indicator elements (ye, ye) switched in parallel and the fourth indicator element (rd) has a potential that is so low that the fourth indicator element (rd) is disabled and in that, if a disturbance or malfunction occurs, the potential at the node (P1, K1) is so high that the fourth indicator element (rd) is enabled.

8. Plug-in connector as claimed in one or more of the previous claims,
wherein the indicator elements (gn, ye, ye, rd) are light emitting diodes (LED), wherein the first light emitting diode is lit in a first color, preferably a green color, and characterizes the operating state of the field device, wherein the second and third light emitting diodes (ye, ye) are lit in a second color, preferably a yellow color, and indicate the two antivalent switch outputs (MIN, MAX), and wherein the fourth light emitting diode (rd) is lit in a third color, preferably a red color, and signals the disturbance and/or malfunction.

9. Plug-in connector as claimed in Claim 8,
wherein a Zener diode (D3) is provided at least in the anode branch of the fourth light emitting diode (rd).

## Revendications

1. Connecteur destiné au raccordement d'un appareil de terrain de la technique d'automatisation avec une alimentation en énergie et/ou une unité d'exploitation, le connecteur comportant un connecteur de raccordement (M12) pour l'appareil de terrain, qui est constitué au moins partiellement d'un matériau transparent, au moins quatre éléments d'affichage (gn, ye, ye, rd) étant disposés dans le connecteur de raccordement (M12), un premier élément d'affichage (gn) signalisant la disponibilité de fonctionnement de l'appareil de terrain, un deuxième et un troisième élément d'affichage (ye, ye) signalisant deux sorties de commutation antivalentes (MIN, MAX) de l'appareil de terrain, un quatrième élément d'affichage (rd) signalisant un dérangement ou un dysfonctionnement de l'appareil de terrain, un circuit (NOR, XNOR) étant prévu, lequel est conçu de telle sorte qu'au moyen des sorties de commutation antivalentes (MIN, MAX) de l'appareil de terrain est détecté un dérangement ou un dysfonctionnement de l'appareil de terrain et, en cas de détection d'un dérangement ou d'un dysfonctionnement, le quatrième élément d'affichage (rd) est activé,
et pour lequel il s'agit, concernant le circuit, d'un circuit logique (NOR, XNOR), qui est conçu en tant que circuit NOR (NON-OU) ou en tant que circuit XNOR (NON-OU EXCLUSIF).

2. Connecteur selon la revendication 1,
pour lequel le circuit logique (NOR, XNOR) est réalisé en technologie CMOS.

3. Connecteur selon la revendication 1,
pour lequel le circuit logique (NOR, XNOR) est réalisé avec une porte intégrée.

4. Connecteur selon la revendication 1 ou 3,
pour lequel le circuit logique (NOR, XNOR) est réalisé sur une puce intégrée.

5. Connecteur selon la revendication 1,
pour lequel le circuit logique (NOR, XNOR) comporte un élément de commutation (Q1) qui est conçu de telle sorte qu'en cas d'apparition d'un dérangement ou d'un dysfonctionnement, qui est détecté au moyen des sorties de commutation antivalentes (MIN, MAX) raccordées, le quatrième élément d'affichage (rd) disposé en aval est activé.

6. Connecteur selon la revendication 5,
pour lequel il s'agit, concernant l'élément de commutation (Q1), d'un transistor bipolaire, notamment d'un transistor PNP, le deuxième élément d'affichage (ye) et le troisième élément d'affichage (ye) étant commutés en parallèle dans la ligne de base du transistor et le quatrième élément d'affichage (rd) étant disposé dans la ligne de collecteur (K) du transistor, le transistor (Q1) étant câblé de telle sorte à être bloqué en fonctionnement normal et à être passant en cas d'apparition d'un dérangement ou d'un dysfonctionnement.

7. Connecteur selon la revendication 1,
pour lequel le circuit logique (NOR, XNOR) est conçu de telle sorte que le deuxième élément d'affichage (ye) et le troisième élément d'affichage (ye) sont commutés en parallèle et que le quatrième élément d'affichage (rd) est commuté en série avec le deuxième élément d'affichage (ye) et le troisième élément d'affichage (ye), qu'en fonctionnement normal la tension au niveau du noeud (P1, K1) situé entre les deux éléments d'affichage (ye, ye) commutés en parallèle et le quatrième élément d'affichage (rd) possède un potentiel si faible que le quatrième élément d'affichage (rd) est désactivé, et qu'en cas d'apparition d'un dérangement ou d'un dysfonctionnement le potentiel au niveau du noeud (P1, K1) est si élevé que le quatrième élément d'affichage (rd) est activé.

8. Connecteur selon une ou plusieurs des revendications précédentes,
pour lequel il s'agit, concernant les éléments d'affichage (gn, ye, ye, rd) de diodes électroluminescentes (LED), la première diode électroluminescente (gn) s'allumant dans une première couleur, de préférence en couleur verte, et caractérisant l'état de fonctionnement de l'appareil de terrain, la deuxième et la troisième diodes électroluminescentes (ye, ye) s'allumant dans une deuxième couleur, de préférence en couleur jaune, et indiquant l'état des deux sorties de commutation (MIN, MAX) antivalentes, et la quatrième diode électroluminescente (rd) s'allumant dans une troisième couleur, de préférence en couleur rouge, et signalant un dérangement ou un dysfonctionnement.

9. Connecteur selon la revendication 8,
pour lequel est prévue une diode Zener (D3) au minimum dans la branche d'anode de la quatrième diode électroluminescente (rd).
